# EUROPEAN PATENT SPECIFICATION

(11) **EP 4 548 726 B1**
(45) Date of publication and mention of the grant of the patent: **22.10.2025**
(21) Application number: 23798961.1
(22) Date of filing: 03.11.2023
(51) Int. Cl.: H10K 30/88, H10K 85/50

(54) **COATED SOLAR CELL**
BESCHICHTETE SOLARZELLE
CELLULE SOLAIRE REVÊTUE

(30) Priority: 03.11.2022 EP 22205410
(43) Date of publication of application: 07.05.2025
(73) Proprietor: Nanofilm Technologies International Limited, Singapore 535226 (SG); Nanyang Technological University, Singapore 639798 (SG)
(72) Inventor: SHI, Xu, Singapore 535226 (SG); WONG, Lydia Helena, Singapore 639798 (SG); SADHU, Anupam, Singapore 639798 (SG); LIE, Stener, Singapore 639798 (SG)
(74) Representative: Schlich
(86) International application number: PCT/EP2023/080713
(87) International publication number: WO 2024/094872

(56) References cited:
- WO-A1-2009/098241
- US-A1- 2009 252 894
- US-A1- 2020 013 974

## Description

### Introduction

The present invention relates to coated solar cells, and methods of making such coated solar cells.

### Background to the Invention

A solar cell harvests light energy and converts it directly into electricity, having three basic attributes, namely light absorption, separation of charge carriers and separate extraction of carriers. Solar cells are typically mounted on and/or contained within layered support structures, the resulting entity referred to as an assembly (and also sometimes referred to as a solar cell though the solar cell is an internal component thereof) which is usually a sealed unit and can then be described as an encapsulated solar cell. Multiple solar cell assemblies wired together constitute a solar module, usually sealed within a protective casing. Multiple solar modules wired together constitute a solar panel. Solar panels amplify and direct the energy generated from individual solar cells.

Many types of solar cell are known and in widespread use. However, one problem common to solar cells is their longevity. For improved economic efficiency, longer lifetimes are desired. Many solar cells are exposed to harsh environments, leading to damage by abrasion, wind, UV and/or climate, especially rain.

US 2009/252894 A1 describes the use of silicon and oxygen-containing barrier coatings, 500nm thick in examples, to protect moisture sensitive LED devices.

WO 2009/098241 A1 describes the need to hermetically seal a solar cell to protect it from external conditions such as moisture.

US 2020/0013974 A1 describes a solar cell that includes a photoelectric conversion layer containing perovskite, along with a method for producing this solar cell. However, it does not consider the problem of the exposure of the solar cell to moisture and how to prevent this.

One particular type of solar cell has a light-harvesting active layer comprising a perovskite structured material.

However, a disadvantage of perovskite solar cells, and other solar cells to differing extents, is their lack of intrinsic and extrinsic stability. Intrinsic stability issues of solar cells, and in particular perovskite solar cells, have been mitigated in recent years using strategies such as compositional engineering, doping, and incorporation of 2D perovskite.

However, extrinsic instability remains a major issue with solar cells, particularly perovskite solar cells. They are unstable to environmental influence such as water and oxygen, as well as other influences such as thermal stress, photo-influence and mechanical fragility.

An object of the present invention is to address and preferably ameliorate the identified stability problems with solar cells, in particular the extrinsic stability problems. An object of specific embodiments is to provide solar cells having improved stability to water damage and/or air damage.

### Summary of the Invention

Accordingly, the present invention provides a solar cell assembly, comprising:
adjacent layers defining an interior lumen,
sealant between the adjacent layers to seal the interior lumen, and
a solar cell within the sealed lumen,
characterised in that an external surface of the assembly is coated with a layer comprising ta-C, said layer having a thickness of up to 50nm and an sp³ content of 60% or greater, and the solar cell is a perovskite solar cell.

A solar cell assembly of the invention can be made by a method comprising:
(i) providing adjacent, e.g. front and back, layers that when sealed together define an interior lumen,
(ii) providing a solar cell between the layers, wherein the solar cell is a perovskite solar cell,
(iii) locating sealant between the layers to seal the layers together and create a sealed interior lumen containing the solar cell,
(iv) applying a layer comprising ta-C to an external surface of the assembly.

It is found that solar cell assemblies of the invention, as shown in examples below, exhibit improved stability.

### Detailed Description of the Invention

A solar cell assembly of the invention hence comprises:
adjacent layers defining an interior lumen,
sealant between the adjacent layers to seal the interior lumen, and
a solar cell within the sealed lumen,
wherein an external surface of the assembly is coated with a layer comprising ta-C, said layer having a thickness of up to 50nm and an sp³ content of 60% or greater, and wherein the solar cell is a perovskite solar cell.

Reduced ingress of water and/or air/oxygen, achieved using the sealing effect of the ta-C coating, results in improved stability.

Typically, the coating layer comprising ta-C is present on one or more of the adjacent layers and/or the sealant.

The coating layer comprising ta-C can be on a back layer of the assembly, or on the front layer, or on both.

Optionally, the sealant comprises ta-C or comprises a coating layer comprising ta-C.

The assembly is preferably characterised in that a coating layer comprising ta-C is present at the junctions between the sealant and each of the adjacent layers. Improved sealing results by the use of ta-C at the junction, where ingress of water and/or air/oxygen can be a particular problem.

In addition to a ta-C coating on the sealant or parts thereof, other surfaces of the solar cell assembly may be ta-C coated. For example, a front layer of the assembly may comprise a coating of ta-C, preferably at least on an outer surface thereof. **In** typical methods of making this assembly, a substrate layer is pre-coated with ta-C prior to being formed into a solar cell assembly. Thus, the front and/or back assembly layers may be coated on an outer surface with ta-C, in addition to the ta-C on the sealant between the layers. To coat the sealant, suitably the edges of the front and back layers are coated.

In methods of applying the coating, ta-C is coated onto an assembly in a coating chamber. The ta-C coating may be applied to, and therefore coat, all of an outer edge of the front layer, an outer edge of the back layer and the sealant. In other words, the ta-C may coat substantially the whole side of the assembly, achieving a desired aim of coating the junctions between sealant and front and back layers.

In some embodiments, all of the back layer, the front layer and the sealant are coated with a coating layer comprising ta-C.

The adjacent layers of a preferred assembly are thus a front layer, also referred to and shown in the figures as a lower layer, and a back layer, also referred to and shown in the figures as an upper layer. The front layer may be or comprise a substrate to which the solar cell is attached and/or on which the solar cell has been formed. The back layer may also comprise an electrode. As described in an example below, the solar cell can be made in situ, on e.g. a glass substrate (or layer) and then encapsulated within the front and back layers. As a result, the lumen is created and sealed between the layers, the lumen generally comprising an air gap as well as the solar cell. As will be appreciated, this air gap is typically very small; nevertheless, ingress of water and/or moisture into this gap is a problem addressed in the invention.

In a solar cell assembly of the invention, light accesses the active components of the solar cell through the front and/or back layers. Suitably, the front layer is made of or comprises a transparent material. Another option is for both the front and back layers to be made of or comprise a transparent material. In embodiments of the invention, the transparent material is glass, epoxy or polymer.

Photovoltaic (PV) glass is typically used to encapsulate each photovoltaic solar cell. PV glass may be used because it is highly transparent, durable and stable under solar radiation. The glass is separate from the solar cell, it is added for protection of the solar cell but does additionally become a functional component of solar modules.

In particular embodiments of the invention the solar cell comprises soda-lime-silica (SLS) glass. Borosilicate may also be used for the PV glass. Other alternatives to PV glass can also be used - e.g. plexiglass/acrylic or tempered glass. These alternatives may reduce the light transmittance through the solar cell assembly, thus reducing the power conversion efficiency of the solar cell, but they do provide more protection from environmental influences.

Alternatively, transparent polymers may be used on their own or in combination with glass. For example, materials like epoxy, TPU and PET can be used in place of glass.

Preferably, all external surfaces of the assembly comprise a coating layer comprising ta-C. In particular embodiments of the invention the assembly is an encapsulated solar cell and all external surfaces thereof comprise a coating layer comprising ta-C.

Components of the solar cell assembly/module are sealed together. Sealants are conventional in the manufacture of solar cells and the invention applies in general to all such useful sealants. Suitable sealants include epoxy resin, ethylene-vinyl acetate, ionomeric polymers (e.g. polyethylene ionomer, such as Surlyn^{®}), polydimethyl siloxane, poly (methyl methacrylate) (PMMA), thermoplastic polyurethane (TPU), polyisobutylene and any mixture thereof. Fluoro polymers (e.g. PTEE), polyethylene terephthalate, poly (vinyl alcohol-co-ethylene)(EVOH), paraffin, organo siloxane, silicone and any mixture thereof can also be used as sealants. Epoxy resin is a preferred sealant, used in the example below.

In this field, epoxy resin is known to be a high strength sealant with impressive core toughness. It offers improved protection against other sealants and has improved ability to resist environmental/chemical influences. Hitherto, the sealing properties of epoxy resin were regarded as satisfactory. The epoxy resin or its interface with solar cell components (e.g. glass layers, substrates, etc) has not till now been identified as a factor contributing to the stability problems in solar cells. One feature of the invention is identifying a problem, namely that the sealant used for the solar cells, often but not always epoxy, has unacceptable barrier properties (in particular towards oxygen and moisture) and/or there is unacceptable sealing at the junction between the sealant (commonly epoxy-based) and the solar cell layers, e.g. glass.

In preferred embodiments, the coating layer comprising ta-C consists of ta-C.

The ta-C coating may in general be of various thicknesses. The layer comprising ta-C usually has a thickness of 0.3nm or greater, or 0.5 nm or greater. As will be appreciated, above certain thicknesses little or no further improved sealing may be achieved. For solar cell assemblies of the invention, the thickness is up to 50nm. Typically, the thickness is from 1nm to 50nm. In preferred embodiments the thickness is from 5nm to 20nm or from 5nm to 10nm. Typically, the ta-C coating is applied directly to the solar cell assembly. For coatings of increased thickness, say 50nm and above, it is optional to deposit a seed layer onto the assembly and then the ta-C layer. A thin seed layer such as Ti, Cr, NiCr, Ni, Si may be present between the assembly and ta-C coating, which may allow a thicker ta-C coating to be present without delamination.

Perovskite solar cells are solar cells which use a perovskite-structured compound (referring to the specific crystal structure) as the light harvesting active layer. Perovskite is a crystal structure, generally with formula ABX3, where X is an anion and both A and B are organic or inorganic cations. The perovskite structured material is usually hybrid organic/inorganic and halide based. Examples of A include Cs, methylammonium (MA) and formamidinium (FA); examples of B include Pb and Sn. A and B are two cations with the valency of 1⁺ and 2⁺ respectively, and X is a halide anion (such as I, Br, Cl) with the valency of 1⁻. Commonly used perovskite materials include MAPbI₃, FAPbI₃, CsPbI₃ and MAₓFA(₁₋ₓ)PbI₃. There are various other mixed cation/anion compositions where various ratios of cation and anions are used.

The perovskite is typically placed between two electrodes which connect to an external circuit. There can be layers between the perovskite and electrodes which can draw out specific charges; in some cells these layers are the hole transport layer and electron transport layer. Materials for the hole transport layer include metal oxides (e.g., NiO, Cu₂O, CuGaO₂), metal sulfides, metal oxysulfides and or organic materials such as P3HT, PTAA and PEDOT:PSS. The electron transport layer can be made from materials such as PCBM, C60, TiO₂ and SnO₂. Optionally, a buffer layer containing materials such as BCP, ZnO and Nb-TiOₓ is deposited in order to improve the contact between the top electrode and the electron transport layer. The top electrode of the solar cell can be made from metals such as silver, gold, copper or aluminium. The electrode at the front side (or light entry side) of the solar cell is usually made of a transparent conductive oxide, such as indium tin oxide, aluminium-doped zinc oxide or fluorine-doped tin oxide.

Perovskite solar cells can be p-i-n or n-i-p structured cells, sometimes referred to as inverted or normal structures. In general, the cells comprise a first electrode, a hole transport layer, perovskite, an electron transport layer and a second electrode. The pi-n cells comprise (in order) top electrode, electron transport layer, perovskite, hole transport layer, front side electrode. The n-i-p cells comprise (in order) top electrode, hole transport layer, perovskite, electron transport layer, front side electrode. The sealing of the invention is believed suitable for a variety of device structures and architectures.

Advantages of using perovskite solar cells include ease of production and high efficiency at low production costs. Disadvantages of stability as described elsewhere are addressed in the present invention.

In a specific embodiment there is provided an encapsulated perovskite solar cell, having front and back layers made of glass and sealed using epoxy sealant/adhesive, comprising an inner lumen between the two layers in which is located the perovskite solar cell, wherein the outer surfaces thereof are coated with a ta-C coating of 1-50nm depth. In a specific example, made and tested as described below, the ta-C coating was about 20nm and gave good results.

Also provided by the invention are methods of making the solar cell assembly, wherein the solar cell is a perovskite solar cell. One such method comprises:
(i) providing adjacent, e.g. front and back, layers that when sealed together define an interior lumen,
(ii) providing a solar cell between the layers,
(iii) locating sealant between the layers to seal the layers together and create a sealed interior lumen containing the solar cell,
(iv) applying a layer comprising ta-C to an external surface of the assembly.

The sealant is usually applied at or towards the outside edges of the layers being sealed together. The solar cell may be formed on the front layer prior to sealing the solar cell between the layers.

The methods suitably produce an assembly as per the above-described optional and preferred features of the invention.

Amorphous carbon is a free, reactive form of carbon which does not have a crystalline form. Various forms of amorphous carbon films exist and these are usually categorised by the hydrogen content of the film and the sp²:sp³ ratio of the carbon atoms in the film.

In an example of the literature in this field, amorphous carbon films are categorised into 7 categories (see table below taken from "Name Index of Carbon Coatings" from Fraunhofer Institut Schich- und Oberflächentechnik):

| **Amorphous Carbon Films** | | | | | | |
|---|---|---|---|---|---|---|
| Hydrogen-Free | | | Hydrogenated | | | |
| Unmodified | | Modified | Unmodified | | Modified with | |
| | | With metals | | | Metals | Non-metals |
| sp² | sp³ | sp² | sp² or sp³ | sp³ | sp² | sp² |
| Hydrogen-free amorphous carbon | Tetrahedral, hydrogen-free amorphous carbon | Metal-containing, hydrogen-free amorphous carbon | Hydrogenate d amorphous carbon | Tetrahedral, hydrogenate d amorphous carbon | Metal-containing, hydrogenated amorphous carbon | Non-metal containing hydrogenate d amorphous carbon |
| **a-C** | **ta-C** | **a-C:Me** | **a-C:H** | **ta-C:H** | **a-C:H:Me** | **a-C:H:X** |

Tetrahedral hydrogen-free amorphous carbon (ta-C) is characterised in that it contains little or no hydrogen (less than 5%mol, typically less than 2%mol) and a high content of sp³ hybridised carbon atoms (typically greater than 80% of the carbon atoms being in the sp³ state). Ta-C sp² and sp³ levels are suitably measured by XPS (see e.g. https://doi.org/10.1016/j.diamond.2003.11.077). Ta-C density is suitably measured using SIMS or RBS (see e.g. https://doi.org/10.1016/S0257-8972(02)00247-5).

Whilst the term "diamond-like carbon" (DLC) is sometimes used to refer to all forms of amorphous carbon materials, the term as used herein refers to amorphous carbon materials other than ta-C. Common methods of DLC manufacture use hydrocarbons (such as acetylene), hence introducing hydrogen into the films (in contrast to ta-C films in which the raw material is typically hydrogen free high purity graphite).

The ta-C coating may be deposited using known technology, e.g. physical vapor deposition, of which one known technique is cathodic vapor arc deposition methods. In this method, an electric arc is used to vaporize material from a cathode target. Consequently, the resulting vaporized material condenses on a substrate to form a thin film of coating. Cathode arc deposition of tetrahedral amorphous carbon, metallic, dielectric and other such coatings is known in the art and offers the potential for deposition of thin films of high quality.

Ta-C is a dense amorphous material described as composed of disordered sp³, interlinked by strong bonds, similar to those that exist in disordered diamond (see Neuville S, "New application perspective for tetrahedral amorphous carbon coatings", QScience Connect 2014:8, http://dx.doi.org/10.5339/connect.2014.8). Due to its structural similarity with diamond, ta-C also is a very hard material with hardness values often greater than 30 GPa.

For use in the invention, the ta-C may have a hydrogen content less than 10%, typically 5% or less, preferably 2% or less (for example 1% or less). The percentage content of hydrogen provided here refers to the molar percentage (rather than the percentage of hydrogen by mass). The ta-C is preferably not doped with other materials (either metals or non-metals). In preferred embodiments of the invention, as described in examples set out in detail below, the assemblies are coated with substantially hydrogen-free ta-C.

It is believed that ta-C coatings used in the invention generally achieve improved sealing. The sp³ carbon content is 60% or higher. It may range up to 95%. In some embodiments, higher sp³ carbon content contributes to improved sealing. In preferred embodiments the ta-C has an sp³ content of 70% or higher, even more preferably above 80%.

The ta-C coating of the present invention is typically deposited by filtered cathodic vacuum arc (FCVA) and/or by sputtering, and machines and processes for both sputter and ta-C deposition by FCVA are conventional and known in the art, hence they are not features of the present invention. As will be appreciated, these coatings are carbon coatings and are preferably substantially silicon-free and oxygen-free. A suitable method and apparatus are described in WO/2012/044258, disclosing an "X-bend" system. Another example of a suitable deposition method is described in WO 2009/151404. A further example of a suitable deposition method is described in WO 2020/187744 - in particular the use of an adhesion promoting layer is described in this application. The ta-C coating of the present invention is preferably deposited by FCVA. As appreciated by the skilled person, FCVA apparatus produce a coating beam comprising positively charged, C⁺ ions for depositing ta-C coatings.

### Examples

The present invention is now described in more specific detail with reference to the accompanying drawings in which:
Fig. 1 shows a schematic top view of a perovskite device stack;
Fig. 2 shows a schematic cross-section of solar cell devices, being (a) a control and (b) - (e) embodiments of the invention;
Fig. 3 shows an image of three of the devices shown schematically in Fig. 2, namely the control, TAC-1 and TAC-2, after a 6900-hour stability test; and
Fig. 4 shows normalized power conversion efficiency (PCE) across 6900 hours of three of the devices shown schematically in Fig. 2, namely the control, TAC-1 and TAC-2.

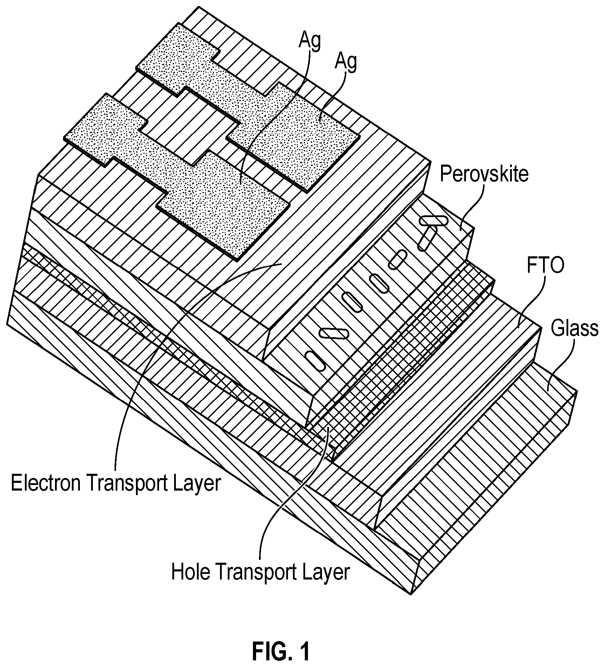

Referring to the figures, Fig.1 shows a schematic top view of a perovskite device stack which is to be incorporated into a coated solar cell of the invention. The device shown in Fig. 1 is an inverted (p-i-n) structure perovskite solar cell.

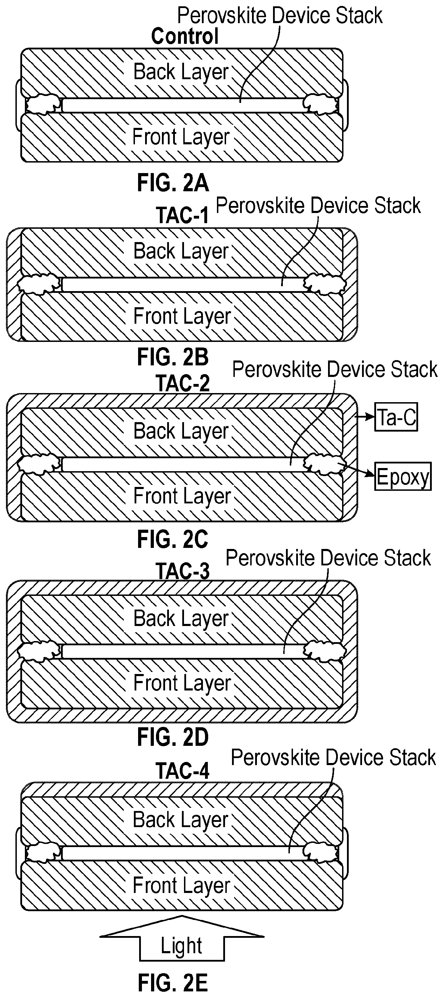

Fig. 2 shows five perovskite stack devices, namely a control (prior art) and examples of the invention, namely TAC-1, TAC-2, TAC-3 and TAC-4.

The control is a conventional perovskite solar cell, encapsulated using lime-soda-silica (SLS) glass and sealed using epoxy sealant. "TAC-1" was encapsulated using normal SLS glass and then a layer of ta-C was coated on the edges after sealing using epoxy. "TAC-2" was encapsulated using ta-C coated SLS glass for the back layer and normal SLS glass for the front layer and a layer of ta-C was coated on the edges after sealing using epoxy. "TAC-3" was encapsulated using ta-C coated SLS glass for both the front and back layers and a layer of ta-C was coated on the edges after sealing using epoxy. "TAC-4" was encapsulated using a layer of ta-C coated SLS glass for the back layer and normal SLS glass for the front layer and sealed using epoxy.

The perovskite solar cell devices used in the experiments are made from the following materials:
Hole transport layer: Nickel oxide (NiOₓ)
Perovskite layer: Triple cation perovskite (Cs_{0.05}(MA_{0.17}FA_{0.83})_{0.95}Pb(I_{0.83}Br_{0.17})₃)
Electron transport layer: Phenyl-C61-butyric acid methyl ester (PCBM)
Buffer layer (thin layer between PCBM and Ag): Bathocuproine (BCP)
Electrode: Ag.

The thickness of the nickel oxide layer is about 50nm, the perovskite layer in the range of 300 to 500nm, the PCBM layer about 50nm, BCP layer 5nm, and the Ag electrode 80-100nm.

The SLS glass is of 1-mm in thickness and is directly placed on the Ag electrode. The thin film stack is directly deposited on a fluoride-doped tin oxide (FTO) glass substrate. To clarify, FTO glass refers to a SLS glass coated with a layer of FTO film.

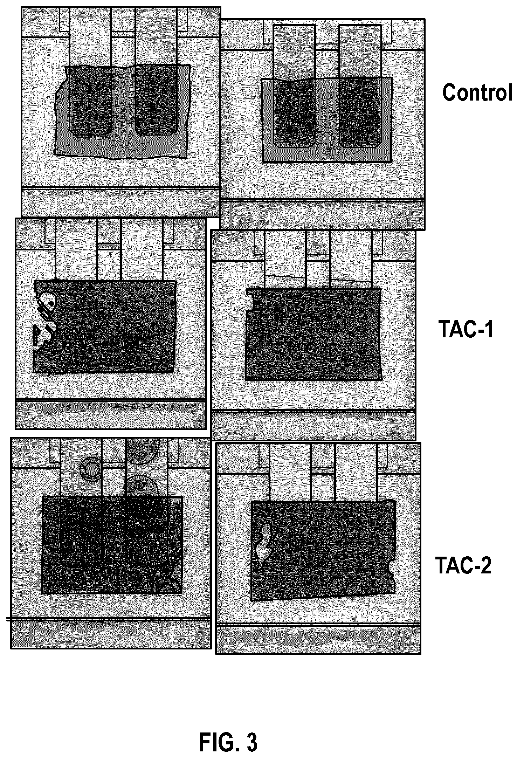

Fig. 3 shows the results of testing the stability of three of these devices, namely the control, TAC-1 and TAC-2. It shows that the control device displays the maximum degradation after 6900 hours, while the ta-C coated devices, TAC-1 and TAC-2 are visually still intact.

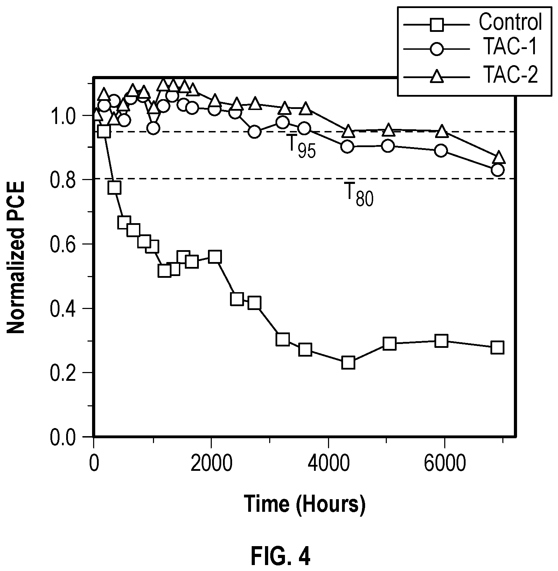

Fig. 4 shows graphically the results of stability testing of the same three devices. Each data point on the graph corresponds to the mean PCE of a range of 3 to 6 devices. It shows that the control device displays the maximum degradation whereas after 6900 hours at 50% RH and 20°C the ta-C coated devices, TAC-1 and TAC-2, have not yet reached their T₈₀ lifetime (with T₈₀ referring to time taken for the PCE to decrease by 20% from the initial value) within the timeframe measured. Additionally, the devices display T₉₅ lifetimes (time taken for PCE to decrease by 5%) 28 and 34 times longer than the control, respectively. The T₉₅ lifetime of the control device was found to be 127 hours, whereas the T₉₅ lifetime of TAC-1 and TAC-2 devices were 3614 and 4351 hours, respectively. Thus, the solar cells treated according to the invention demonstrated improved stability.

In more detail, the perovskite solar cell was fabricated on a fluoride-doped tin oxide (FTO) substrate. An etched FTO substrate was cleaned in soapy water and an ethanol bath, then air-dried and treated in a UV-ozone chamber to make its surface more hydrophilic. The cleaned FTO substrate was then coated with hole transporting layers. An organic-inorganic hybrid perovskite layer was deposited using an antisolvent assisted method in an inert atmosphere. The film was then annealed at a temperature between 100-135°C. Following that, the electron transporting layer was deposited using a spin coating method. The film was then annealed below the decomposition temperature of perovskite in order to get a compact film. After that a buffer layer was deposited in order to improve the contact between the electrode and the electron transport layer. Finally, a 100nm thick electrode made out of metals like silver, gold, copper and aluminium was thermally evaporated to complete the device fabrication.

The edge of the perovskite device stack was then cleaned before beginning the process of epoxy encapsulation, to make space for the encapsulant. A soda-lime-silica glass was cut in the required dimension and an organic encapsulant was used for edge encapsulation/sealing. The edge encapsulant (sealant) was applied at the edge of the perovskite device stack to attach it to the device, the device was then dried at 60-90°C for 10 minutes to form a mechanically strong encapsulation.

Finally, a ta-C layer (depth approx. 20nm, sp³ content approx. 80%) was deposited on the edges of the device, covering the sealant and its junctions with the front and back device layers to make the device impervious to moisture and oxygen.

For TAC-2, the glass substrate was first coated, with the plasma beam, which contained positively charged carbon ions, substantially orthogonal to the glass plate. The thickness of ta-C coating is 5nm on the glass substrate. The ta-C coated glass was then cut in the required dimension and attached to the perovskite solar stack. Masking was then applied to the top and bottom glass surface while the side surfaces of the solar cell device were then coated by ta-C, without applying any substrate bias. The ta-C coating on the glass surface was kept thin enough to ensure that it was transparent. The ta-C coating on the edges was 20nm, as for other tested devices.

Of course, the coating on the edges can be thicker because it does not need to be transparent, e.g. the coating on the edges may be as thick as 100nm or greater for enhanced function. However, thicker coatings increase cost and production times. For thicker ta-C coatings on the edge surfaces a seed layer is typically used to improve adhesion of the ta-C.

The invention thus provides solar cells coated with ta-C, and methods and apparatus therefor.

## Claims

1. A solar cell assembly, comprising:
adjacent layers defining an interior lumen,
sealant between the adjacent layers to seal the interior lumen, and
a solar cell within the sealed lumen,
**characterised in that** an external surface of the assembly is coated with a layer comprising tetrahedral hydrogen-free amorphous carbon, ta-C, said layer having a thickness of up to 50nm and an sp3 content of 60% or greater, and the solar cell is a perovskite solar cell.

2. A solar cell assembly according to claim 1, wherein said ta-C layer has an sp3 content of 70% or greater.

3. A solar cell assembly according to claim 1 or 2, wherein the coating layer comprising ta-C is present on one or more of the adjacent layers and/or the sealant.

4. A solar cell assembly according to any of claims 1 to 3, wherein the coating layer comprising ta-C is present at the junctions between the sealant and each of the adjacent layers.

5. A solar cell assembly according to any of claims 1 to 4, wherein the adjacent layers of the assembly are a front layer and a back layer, wherein the front layer is or comprises a substrate to which the solar cell is attached and/or on which the solar cell has been formed.

6. A solar cell assembly according to claim 5, wherein the back layer of the assembly comprises a coating of ta-C.

7. A solar cell assembly according to claim 5 or 6, wherein the coating layer comprising ta-C coats all of an outer edge of a front layer, an outer edge of a back layer and the sealant.

8. A solar cell assembly according to any preceding claim, wherein a front layer, and optionally a back layer, is made of or comprises a transparent material, for example glass, epoxy or polymer.

9. A solar cell assembly according to claim 8, wherein the transparent material is glass (e.g. soda-lime-silica glass).

10. A solar cell assembly according to any preceding claim, wherein the sealant is selected from epoxy resin, ethylene-vinyl acetate, epoxy resin, polyethylene ionomer, polydimethyl siloxane, poly (methyl methacrylate) (PMMA), thermoplastic polyurethane (TPU), and polyisobutylene, fluoro polymers (e.g. PTFE), polyethylene terephthalate, poly (vinyl alcohol-co-ethylene) (EVOH), paraffin, organo siloxane, silicone or any mixture thereof.

11. A solar cell assembly according to claim 10, wherein the sealant is epoxy resin.

12. A solar cell assembly according to any preceding claim, comprising two electrodes, a hole transport layer, an electron transport layer and perovskite.

13. A solar cell assembly according to claim 12, wherein the hole transport layer comprises metal oxides (e.g., NiO, Cu₂O, CuGaO₂), metal sulfides, metal oxysulfides and / or organic materials such as P3HT, PTAA and PEDOT:PSS, and the electron transport layer comprises PCBM, C60, TiO₂ or SnO₂.

14. A solar cell assembly according to any preceding claim, wherein the assembly is an encapsulated solar cell and all external surfaces thereof comprise a coating layer comprising ta-C.

15. A solar cell assembly according to claim 14, comprising a first electrode, a hole transport layer, perovskite, an electron transport layer and a second electrode.

16. A method of making a solar cell assembly according to any preceding claim, comprising:
(i) providing adjacent, e.g. front and back, layers that when sealed together define an interior lumen,
(ii) providing a perovskite solar cell between the layers,
(iii) locating sealant between the layers to seal the layers together and create a sealed interior lumen containing the solar cell,
(iv) applying a layer comprising ta-C to an external surface of the assembly.

## Patentansprüche

1. Solarzellenanordnung, umfassend:
benachbarte Schichten, die ein Innenlumen definieren,
ein Dichtmittel zwischen den benachbarten Schichten, um das Innenlumen abzudichten, und
eine Solarzelle innerhalb des abgedichteten Lumens,
**dadurch gekennzeichnet, dass** eine äußere Oberfläche der Anordnung mit einer Schicht beschichtet ist, die tetraedrischen wasserstofffreien amorphen Kohlenstoff, ta-C, umfasst,
wobei die Schicht eine Dicke von bis zu 50 nm und einen sp3-Gehalt von 60 % oder mehr aufweist und die Solarzelle eine Perowskit-Solarzelle ist.

2. Solarzellenanordnung nach Anspruch 1, wobei die ta-C-Schicht einen sp3-Gehalt von 70 % oder mehr aufweist.

3. Solarzellenanordnung nach Anspruch 1 oder 2, wobei die Beschichtungsschicht, die ta-C umfasst, auf einer oder mehreren der benachbarten Schichten und/oder dem Dichtmittel vorhanden ist.

4. Solarzellenanordnung nach einem der Ansprüche 1 bis 3, wobei die Beschichtungsschicht, die ta-C umfasst, an den Übergängen zwischen dem Dichtmittel und jeder der benachbarten Schichten vorhanden ist.

5. Solarzellenanordnung nach einem der Ansprüche 1 bis 4, wobei die benachbarten Schichten der Anordnung eine vordere Schicht und eine hintere Schicht sind, wobei die vordere Schicht ein Substrat ist oder umfasst, an dem die Solarzelle befestigt ist und/oder auf dem die Solarzelle ausgebildet wurde.

6. Solarzellenanordnung nach Anspruch 5, wobei die hintere Schicht der Anordnung eine Beschichtung aus ta-C umfasst.

7. Solarzellenanordnung nach Anspruch 5 oder 6, wobei die Beschichtungsschicht, die ta-C umfasst, eine Außenkante einer vorderen Schicht, eine Außenkante einer hinteren Schicht und das Dichtmittel vollständig beschichtet.

8. Solarzellenanordnung nach einem vorhergehenden Anspruch, wobei eine vordere Schicht und optional eine hintere Schicht aus einem transparenten Material, beispielsweise Glas, Epoxid oder Polymer, hergestellt ist oder dieses umfasst.

9. Solarzellenanordnung nach Anspruch 8, wobei das transparente Material Glas (z. B. Kalk-Natron-Silikatglas) ist.

10. Solarzellenanordnung nach einem vorhergehenden Anspruch, wobei das Dichtmittel aus Epoxidharz, Ethylenvinylacetat, Epoxidharz, Polyethylenionomer, Polydimethylsiloxan, Poly(methylmethacrylat) (PMMA), thermoplastischem Polyurethan (TPU) und Polyisobutylen, Fluorpolymeren (z. B. PTFE), Polyethylenterephthalat, Poly(vinylalkohol-Coethylen) (EVOH), Paraffin, Organosiloxan, Silikon oder einer beliebigen Mischung davon ausgewählt ist.

11. Solarzellenanordnung nach Anspruch 10, wobei das Dichtmittel Epoxidharz ist.

12. Solarzellenanordnung nach einem vorhergehenden Anspruch, umfassend zwei Elektroden, eine Lochtransportschicht, eine Elektronentransportschicht und Perowskit.

13. Solarzellenanordnung nach Anspruch 12, wobei die Lochtransportschicht Metalloxide (z. B. NiO, Cu₂O, CuGaO₂), Metallsulfide, Metalloxysulfide und / oder organische Materialien wie P3HT, PTAA und PEDOT:PSS umfasst und die Elektronentransportschicht PCBM, C60, TiO₂ oder SnO₂ umfasst.

14. Solarzellenanordnung nach einem vorhergehenden Anspruch, wobei die Anordnung eine verkapselte Solarzelle ist und alle äußeren Oberflächen davon eine Beschichtungsschicht umfassen, die ta-C umfasst.

15. Solarzellenanordnung nach Anspruch 14, umfassend eine erste Elektrode, eine Lochtransportschicht, Perowskit, eine Elektronentransportschicht und eine zweite Elektrode.

16. Verfahren zum Herstellen einer Solarzellenanordnung nach einem vorhergehenden Anspruch, umfassend:
(i) Bereitstellen benachbarter, z. B. vorderer und hinterer, Schichten, die, wenn sie miteinander abgedichtet sind, ein Innenlumen definieren,
(ii) Bereitstellen einer Perowskit-Solarzelle zwischen den Schichten,
(iii) Anordnen eines Dichtmittels zwischen den Schichten, um die Schichten miteinander abzudichten und ein abgedichtetes Innenlumen zu schaffen, das die Solarzelle enthält,
(iv) Aufbringen einer Schicht, die ta-C umfasst, auf eine äußere Oberfläche der Anordnung.

## Revendications

1. Ensemble cellule solaire, comprenant :
des couches adjacentes définissant une lumière intérieure,
un matériau d'étanchéité entre les couches adjacentes pour sceller la lumière intérieure, et
une cellule solaire à l'intérieur de la lumière scellée,
**caractérisé en ce qu'**une surface extérieure de l'ensemble est revêtue d'une couche comprenant du carbone amorphe exempt d'hydrogène tétraédrique, ta-C,
ladite couche présentant une épaisseur allant jusqu'à 50 nm et une teneur en sp3 supérieure ou égale à 60 %, et la cellule solaire est une cellule solaire en pérovskite.

2. Ensemble cellule solaire selon la revendication 1, ladite couche de ta-C possédant une teneur en sp3 supérieure ou égale à 70 %.

3. Ensemble cellule solaire selon la revendication 1 ou 2, ladite couche de revêtement comprenant du ta-C étant présente sur une ou plusieurs des couches adjacentes et/ou le matériau d'étanchéité.

4. Ensemble cellule solaire selon l'une quelconque des revendications 1 à 3, ladite couche de revêtement comprenant du ta-C étant présente au niveau des jonctions entre le matériau d'étanchéité et chacune des couches adjacentes.

5. Ensemble cellule solaire selon l'une quelconque des revendications 1 à 4, lesdites couches adjacentes de l'ensemble étant une couche avant et une couche arrière, ladite couche avant étant ou comprenant un substrat auquel la cellule solaire est fixée et/ou sur lequel la cellule solaire a été formée.

6. Ensemble cellule solaire selon la revendication 5, ladite couche arrière de l'ensemble comprenant un revêtement de ta-C.

7. Ensemble cellule solaire selon la revendication 5 ou 6, ladite couche de revêtement comprenant du ta-C recouvrant tout un bord externe d'une couche avant, un bord externe d'une couche arrière et le matériau d'étanchéité.

8. Ensemble cellule solaire selon une quelconque revendication précédente, une couche avant, et éventuellement une couche arrière, étant constituées d'un matériau transparent, par exemple du verre, de l'époxy ou un polymère ou comprenant celui-ci.

9. Ensemble cellule solaire selon la revendication 8, ledit matériau transparent étant du verre (par exemple, du verre silico-sodo-calcique).

10. Ensemble cellule solaire selon une quelconque revendication précédente, ledit matériau d'étanchéité étant choisi parmi une résine époxy, un éthylène-acétate de vinyle, une résine époxy, un ionomère de polyéthylène, un polydiméthylsiloxane, un poly(méthacrylate de méthyle) (PMMA), un polyuréthane thermoplastique (TPU) et un polyisobutylène, des polymères fluorés (par exemple, le PTFE), un poly(téréphtalate d'éthylène), un poly (alcool vinylique-co-éthylène) (EVOH), une paraffine, un organosiloxane, un silicone ou un quelconque mélange de ceux-ci.

11. Ensemble cellule solaire selon la revendication 10, ledit matériau d'étanchéité étant une résine époxy.

12. Ensemble cellule solaire selon une quelconque revendication précédente, comprenant deux électrodes, une couche de transport de trous, une couche de transport d'électrons et de la pérovskite.

13. Ensemble cellule solaire selon la revendication 12, ladite couche de transport de trous comprenant des oxydes métalliques (par exemple, NiO, Cu₂O, CuGaO₂), des sulfures métalliques, des oxysulfures métalliques et/ou des matériaux organiques tels que P3HT, PTAA et PEDOT :PSS, et ladite couche de transport d'électrons comprenant PCBM, C60, TiO₂ ou SnO₂.

14. Ensemble cellule solaire selon une quelconque revendication précédente, ledit ensemble étant une cellule solaire encapsulée et toutes ses surfaces externes comprenant une couche de revêtement comprenant du ta-C.

15. Ensemble cellule solaire selon la revendication 14, comprenant une première électrode, une couche de transport de trous, de la pérovskite, une couche de transport d'électrons et une seconde électrode.

16. Procédé de fabrication d'un ensemble cellule solaire selon une quelconque revendication précédente, comprenant :
(i) la fourniture de couches adjacentes, par exemple avant et arrière, qui, lorsqu'elles sont scellées ensemble, définissent une lumière intérieure,
(ii) la fourniture d'une cellule solaire en pérovskite entre les couches,
(iii) le placement d'un matériau d'étanchéité entre les couches pour sceller les couches ensemble et créer une lumière intérieure scellée contenant la cellule solaire,
(iv) l'application d'une couche comprenant du ta-C sur une surface externe de l'ensemble.
